# EUROPEAN PATENT APPLICATION

(11) **EP 4 075 153 A1**
(43) Date of publication of application: **19.10.2022**
(21) Application number: 21167790.1
(22) Date of filing: 12.04.2021
(51) Int. Cl.: G01R 29/12, B82Y 15/00, G01R 29/08, H01L 29/66

(54) **LOW TEMPERATURE OSCILLOSCOPE**

(71) Applicant: Qdevil ApS, 2100 Copenhagen Ø (DK); University of Copenhagen, 1165 Copenhagen K (DK)
(72) Inventor: van der Heijden, Joost, 2100 Copenhagen Ø (DK); Kuemmeth, Ferdinand, 2100 Copenhagen Ø (DK); von Soosten, Merlin, 2100 Copenhagen Ø (DK); Andresen, Søren, 2100 Copenhagen Ø (DK); Kühle, Anders, 2100 Copenhagen Ø (DK); Kutchinsky, Jonatan, 2100 Copenhagen Ø (DK)
(74) Representative: Inspicos P/S

(57) **Abstract**

A sensor for a cryogenic operated device, the set-up comprising dual quantum dots positioned so close to a conductor supplying an electrical signal to the device. A charged particle in the quantum dots is affected and moved due to the field, so that detection of the position of the particle will provide information relating to the field and thus the signal.

## Description

The present invention relates to a low temperature oscilloscope and in particular to a sensor and the use thereof for which is positioned within an electrical field of a conductor transporting a signal such as for a cryogenic circuit or device. The electrical field will affect a charged particle in the sensor, and a detection is made in this regard.

The present sensor may be used to characterize the signal waveform, at cryogenic temperatures, which wave form has been perturbed along the non-ideal transmission line from the emitter (generator/source), that may be placed at higher temperature, to a circuit or device operating at cryogenic temperatures.

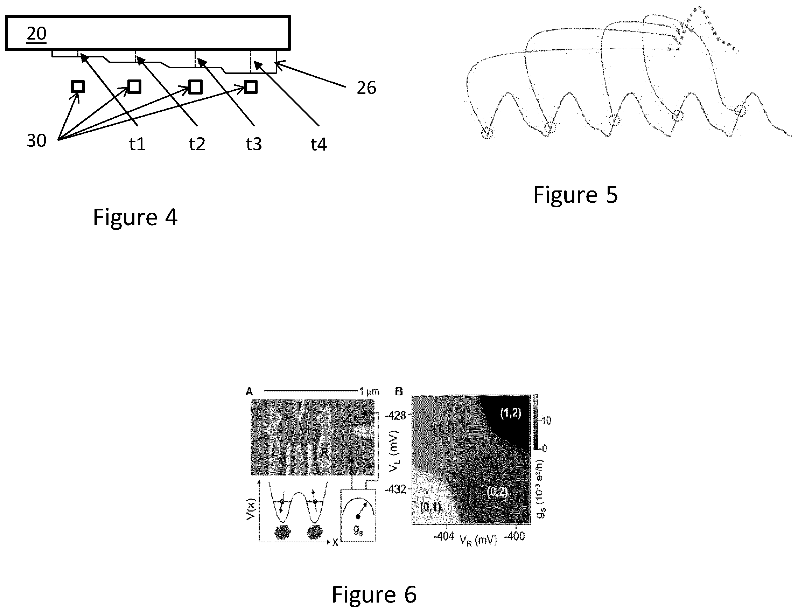

Determination of information from signals in conductors, such as at cryogenic temperatures, may be seen in Petta et. al. Science 309, 2180 (2005); see figure 6.

In a first aspect, the invention relates to a cryogenic operated sensor, the set-up comprising:
- a conductor configured to supply an electric signal,
- a first and a second storage element each configured to store at least one charged particle, the first and second storage elements being positioned so that a current in the conductor creates an electrical field forcing a charged particle in the first storage element in a direction toward one of the first storage position and the second storage element,
- a separating element configured to alter between a first mode and a second mode, where:
   ∘ in the first mode, the separating element allows a charged particle to move between the first and second storage positions and
   ∘ in the second mode, the separating element prevents charged particles from moving between the first and second storage positions and
- a detector for detecting which of the first and second storage element comprises a charged particle.

In this aspect, the sensor may be provided in a desired position vis-à-vis the conductor configured to supply the signal to the cryogenic operated device. The conductor may be used for feeding the signal to any type of device, such as a cryogenic operated device or circuit, such as an information processing circuit, a sensor, a detector, storage circuitry, or a so-called DUT, a qubit or the like. Alternatively, the signal may be supplied to a short, terminator or open ended conductor.

The conductor may be a transmission line, such as a conductor/wire/lead. The conductor and/or the sensor may be at cryogenic temperatures itself, such as at temperatures below 100K, such as below 10K, such as below 1K. The conductor is configured to emit an electrical field, such as a field corresponding to a signal carried by the conductor, such as a field corresponding to a current carried by the conductor. The conductor preferably is not shielded and may be provided on or at an element, such as a PCB on which the sensor or at least the storage elements are provided. Alternatively, the conductor and the storage elements may be provided on separate elements fixed in relation to each other.

In some situations, the conductor may be uncovered, so that the field is readily available. In other situations, the conductor forms part of a shielded coaxial cable outside of which no or an insufficient electrical field may be available. In such situations, the electrical field strength from the signal carrying conductor may be accessed, either by placing the first and second elements of the sensor inside the transmission line dielectric, either in coaxial or planar configuration. Or part of the signal carried by the conductor may be coupled into an auxiliary transmission line, for example by means of a directional or simple capacitive coupler. The signal in the auxiliary line may then be exposed to the sensor without perturbing the signal carried in the main conductor to the cryogenic operated device. Thus, the current creating the field may not be from the signal actually transported in the conductor but may be derived therefrom, via a galvanic connection, and thus correspond thereto.

The operation of the sensor may be seen as a utilization of a charge balance based on localization of charge at two or more discrete sites or storage elements. The sites or storage elements may be electrostatically confined semiconductor dots, electrostatic ion traps, optical traps or more general junction or field effect devices, quantized charge in metallic junction devices or other more exotic many-particle quasiparticles such as Cooper-pairs, Andreev-states or other charged bound states, for example. The charged particle may be a plurality of particles, such as an electrons or holes in a semiconductor, ions or other charged objects placed in electrostatic or optical traps. Preferably a single charged particle is provided. Clearly, positively and negatively charged particles will travel in opposite directions when exposed to an electrical field.

The storage elements are positioned so that the charged particle may move from one storage element and to the other, such as under influence of the electrical field of the conductor. Thus, the first and second storage elements are positioned, relatively, along a direction of the electrical field or preferably at least along an axis no more than 45 degrees from a direction of the electrical field at the position of e.g. the first storage element.

The storage elements may be neighbouring, so that a charge leaving one storage position will be received by the other storage position. Alternatively, one or more additional or intermediate storage positions may be provided between the first and second storage positions, so that a charged particle moving from the first to the second storage position moves through the intermediate storage positions. It may be preferred that the intermediate storage positions are positioned more or less along a straight curve from the first to the second storage positions.

A separating element is provided. The separating element is configured to alter between a first mode and a second mode, where, in the first mode, the separating element allows a charged particle to move between the first and second storage positions and in the second mode, the separating element prevents charged particles from moving between the first and second storage positions. If intermediate storage positions are provided, the separating element may be positioned between one of the first and second storage positions and an intermediate storage position or between two intermediate storage positions. Alternatively, a storage position may be provided with or as the separating element.

In this context, the particle is allowed to move between the first and second storage elements, such as during normal conditions, such as under the influence of the electrical field from the conductor. Thus, in the first mode, the particle should be able to move from the first storage element to the second storage element or vice versa when exposed to an electrical field having a field strength usual for the electrical field carrying the signal. Thus, the separating element, or merely the storage elements and their surroundings, may pose some resistance to the particle moving from one storage element to the other, but this resistance or barrier should be so low that a minimum field strength and thus a minimum current of the signal will force the particle in the direction of the field and to pass from one storage element to the other. In this first mode, the height of the barrier may be lowered to a level where the rate of tunnelling though the barrier is fast compared to the desired time resolution of sampling the electric field, most likely lower than ten times the maximum field strength. Often, noise is present in systems and surroundings. Thus, the barrier height may be selected so high that noise cannot cause the charged particle to move from one storage position to the other.

On the other hand, in the second mode, the particle is prevented from moving from one storage element to the other. Then, the energetic barrier for moving between the storage elements should be so high that the particle will remain in its current storage element even when the signal in the conductor creates an electrical field at a maximum field strength. It may be desired that the barrier height suppresses tunnelling through the barrier by at least 10%, such as by at least 50%, such as by at least 75%, such as by at least 95%. To achieve this, the barrier height may be raised to at least twice the maximum field strength.

Then, the separating element may be adapted to the signal in question, such as to the minimum and maximum electrical field strengths at the first and second storage elements. The first mode should present a barrier below the minimum field strength and the second mode should present a barrier above the maximum field strength.

The operation of the separating element allows sampling of the local electrical field at a clearly defined time instance (with a potential time resolution in the nano-second to millisecond range) by dynamic tuning of the local electrostatics, e.g. barriers or potentials between the storage elements. Bringing the separating element to its second state "freezes" the state and position of the charged particle.

Finally, a detector is provided for detecting in which of the first and second storage element the charged particle is positioned. This may be done by detecting the presence or absence of the particle in one of the storage elements. The detector, thus, may be used for determining the position of the charged particle and therefore e.g. the presence of an electric field smaller or larger compared to the energy required for the particle to move between the two storage positions.

After sampling the electrical field potential by the barrier lifting, the resulting charge state of the storage elements is read-out. Often, a quantum point contact or dot with a pronounced conductance response to local charge is used for read-out. If e.g. a rapid response is desired, RF reflectometry may be used to achieve bandwidths up to tens of MHz. Alternatively, it could be relevant to read-out the charge state of the storage elements directly into a charge register.

Preferably, the sensor comprises a field generator configured to generate, in the first and second storage elements, an internal field oppositely directed to the electrical field from the conductor. The internal field may be an electrical field, a magnetic field or generated by e.g. optics creating a biasing of the particle in the opposite direction to that caused by the electric field. The internal field may be provided only at or around the first and second storage positions but may alternatively be provided also at the conductor, detector(s) and the like if desired.

The sensor/detector principle may be based on operating a charge balance at threshold to result in a binary output that compares the electrical field imposed on the sensor/detector with an internally predefined charge imbalance (internal electrical field).

Then, preferably the sensor further comprises a controller configured to control the field generator and the separating element. The controlling of the field generator could be to generate a field with a desired strength and optionally also direction. The controlling of the separating element could be to alter from the first mode to the second mode at a desired point in time and/or within a desired time period, as described above, that point in time could define an actual time of detecting the electrical field.

The controller may be any type of controller, processor, DSP, ASIC, FPGA or the like, software controlled and/or hardwired. The controller may be formed by a monolithic element or may be provided as an assembly of such elements which are configured to communicate with each other. Naturally, the controller may have any user interface, storage, I/O elements and the like required for it to perform its function.

In addition, the controller could receive an output from the detector. This output could be as simple as in which of the first and second storage elements the charged particle is found. Alternatively, the detector may simply determine whether the particle is or is not detected in e.g. the first storage element.

The controller may then generate information relating to a current/signal carried by the conductor. This information may relate to which of the internal field and electrical field is the largest. This information may be derived from the output of the detector. This output may relate to the position of the charged particle and thus the resulting field acting on the particle. If no other fields, at least of a corresponding field strength, act on the particle, the position of the particle will be indicative of which of the internal field and the electric field is the strongest.

From this information, it may be determined what the minimum or maximum current in the conductor was at the point in time where the separating element moved to the second mode. If the internal field was the strongest, the electric field from the conductor was weaker and the current thus was below a minimum threshold. If the electric field was the strongest, the current was at least or above a maximum threshold.

In a preferred embodiment, each of the first and second storage elements comprises a quantum dot. Quantum dots are well known and well behaved.

In general, the separating element may comprise one or more electrodes configured to generate a barrier between the first and second positions, the barrier, in the first mode, being sufficiently low for the charged particle to pass the barrier, and, in the second mode, being sufficiently high for the charged particle to be prevented from passing the barrier.

A sensor/detector formed by quantum dots could be subject to e.g. single electron charging confined by means of material junction interfaces and/or electrode voltages. Most often, quantum dots are realized by patterned surface electrodes on a semiconductor wafer structure with in-plane electron confinement achieved by junctions in material composition. Double quantum dots have been widely exploited as spin qubits since the demonstration thereof by Petta et. al. Science 309, 2180 (2005); see figure 6.

The preferred embodiment of a storage element or each storage element relies on a semiconductor wafer structure with in-plane electron confinement into a planar two-dimensional electron gas (2DEG) at the material interface between a surface layer of higher band gap and the underlying substrate material. Patterned surface gate electrodes are then used to deplete the 2DEG underneath and form the two quantum dots marked in red. At low temperatures (below 1 K), the number of electrons in each quantum dot is quantized and may be controlled by the gate electrodes (L and R; see figure 6) as illustrated in the plot on the right. Note that the charge state of the double quantum dot is read-out by a nearby charge sensor with a conductance that reacts sensitively to any relocation of nearby change.

The double quantum dot embodiment may be of a type for use as either charge- or spin-based qubits for quantum information processing. Such embodiments may, however, be used as sensors or detectors of the electric field or potential surrounding a signal carrying path. For example, when operated near a charge degeneracy point, e.g. at the line between (1,1) and (0,2), the double dot will be at a balancing point between the two charge states. Any change in the internal electric field (set by the field generator, such as by providing an asymmetry between gates thereof or the electrical field may imbalance the double quantum dot in favour of a certain charge configuration. In addition to tune the imbalance by the field generator, with the L and R gates, the barrier gate (marked T; see figure 6) is used to control the tunnel barrier in between the two quantum dots. It may be lowered, first mode, to allow the single electrons to tunnel easily between the quantum dots and react to any field imbalance imposed internally or externally. Or it may be raised, second mode, to localise the single electrons on each quantum dot in the location preferred under the imposed fields. Based on this, the double quantum dot may be operated to sample the electric field at an instance defined by rapidly raising the barrier potential. At this instance, the resulting charge state of the double quantum dot will depend on a threshold set between the internal field (defined by asymmetry between gates L and R) and the electrical field imposed from the surroundings.

In one embodiment, the sensor comprises a plurality of units each comprising a first and a second storage element, a separating element, a field generator and a detector. Thus, a number of independent sensing units are provided which may be used or combined in a number of manners.

In one manner, the field generators of one unit and the field generator of another of the units are configured to generate different field strengths. When the units utilize different field strengths, the positions of the charged particles will be determined in relation to such different field strengths. As mentioned, the sensitivity of a single unit may be binary in the sense that the position of the charged particle relates to which of the internal field and the electric field is the strongest. Providing a number of units each comparing the electric field to different internal fields, a better sensitivity may be obtained, such as if the separating elements of all units or some of the units move from the first to the second mode at the same point in time. In this situation, it may be desired to have the same field strength of the electric field at the units. If different units see different field strengths of the electric field, this may be known or determined and taken into account.

In another manner, the storage elements of one unit and the storage elements of another of the units are provided at different distances to the conductor. The electric field will have different field strengths at different distances. Thus, the comparison made in each unit will compare the internal field of the unit with the different field strengths of the electric field. In that manner, the field strengths of the internal fields may be the same, as the relation between the internal field and the electric field may still be different in different units.

In yet another manner, a first damping material is provided between the conductor and the storage elements of one unit and a second damping material is provided between the conductor and the storage elements of another unit, the first and second damping materials having different damping of the electrical field. This is yet another manner of providing different field strengths of the electric field in different units.

In general, different manners exist of providing different field strengths of the internal fields and the electric field. Having different field strengths or different relations between the field strengths in different units allows for a more precise determination, if the separating element is operated simultaneously in some of or all of the units.

The operation may be the raising of the barrier or the point in time where the barrier reaches is maximum value or reaches a predetermined percentage, such as 90%, of the maximum value.

In this context, "simultaneously" may be within a predetermined time interval, so that the detection of all units may be assumed to be performed at the same time. Clearly, this may depend on a frequency of the signal, if periodic, or a time resolution with which the signal is desired determined. "simultaneously" may be desired within a time period being a quarter or less of the signal period, such as 10% of the period or less, such as 5% of the period or less, such as 1% of the period or less. If the units are not positioned at the same longitudinal position of the conductor, it may be desired to time shift their detection accordingly.

Also, it may be desired that the raising of the barrier is much faster than a period of a detection frequency, if periodic, such as 10% of the period or less, such as 1% of the period or less.

Alternatively, the relation between the field strengths may be the same, where the separating elements of different units are operated to move from the first to the second mode at different points in time. In this manner, a time evolution of the signal may be determined.

A second aspect of the invention relates to a method of operating the above sensor, the method comprising the following steps:
a) supplying the signal to the conductor,
b) the separating element altering from the first mode to the second mode, and
c) detecting in which storage position the charged particle is.

Naturally, all embodiments, aspects, situations and considerations made above may be equally relevant in relation to the second aspect of the invention.

The sensor may be as described above. The sensor comprises the first and second storage elements, the separating element and the detector.

According to the method, a signal is supplied in the conductor. This signal will emit the electric field. The electric field will correlate with the signal in the conductor, so that knowledge relating to the signal may be derived from knowledge of the electric field. The electric field may increase and decrease in strength in the same manner and on the same time scale as a current of the signal in the conductor increases and decreases. Thus, the signal shape over time may be determined or estimated from the field intensity shape over time.

The conductor emitting the electric field may be provided at cryogenic temperatures, and so may the storage elements, the separating element, the controller and/or the detector.

When the separating element alters from the first mode to the second mode, the position of the charged particle is locked. This position will be derived by or defined by the electric field at the point in time of bringing the separating element to the second mode. As described above, a number of separating elements may be used.

The detection will be a detection of in which storage position the charged particle is. This detection may be performed in each of a number of manners.

Preferably, steps a) and b) are performed simultaneously. Thus, the bringing of the separating element to the second mode will make the position of the charged particle indicative of the electric field strength or direction at that time.

When the method further comprises the step of, during steps a) and b), feeding an internal field, opposite to the electrical field, to the first and second storage elements, the position of the charged particle will depend on the overall field direction experienced by the charged particle and thus which of the electric field and the internal field is the strongest. It is noted that in this respect, the field strength of the electric field is that at the first and/or second storage elements.

In this situation, the method may further comprise the step of generating information relating to the signal based on the internal field and the result of step c). The internal field may be controlled or determined, so that information may be derived relating to the electric field and thus the signal.

In one embodiment, the step of feeding the internal field comprises feeding an internal field corresponding to a first signal, and wherein the step of generating the information comprises generating information relating to a difference between the signal and the first signal. In one situation, the first signal may relate to or correlate to a desired signal in the conductor. Thus, the internal field will relate to this signal, and any difference between the electric field, i.e. the actual signal in the conductor, and the internal field, i.e. the desired signal in the conductor, may be seen from the positions of the charged particle. If the signal strengths of the internal field and the electric field are adapted to each other, the charged particle should see no resulting field, if the two signals correspond. Then, the position of the charged particle would over time be stochastically distributed between the two storage elements. If the signals do not correspond, and the charged particle will see a resulting field and thus have a position determined by this difference.

In one embodiment, step b) comprises raising a barrier between the first and second storage positions from, in the first mode, a level being sufficiently low for the charged particle to pass the barrier, to, in the second mode, a level being sufficiently high for the charged particle to be prevented from passing the barrier. As described above, this barrier may be embodied or obtained in a number of manners. The strength of the barrier may be determined based on the internal field and/or the electric field, such as within an interval of field strength assumed or expected in the electric field.

One manner of obtaining the barrier, when the sensor comprises one or more electrodes, is by providing a voltage to the one or more electrodes.

In one embodiment, a plurality of sensors or sensor units is operated simultaneously. These sensors or sensor units may be identical or different. The sensor units may be operated identically or differently.

In one manner, an attenuation of the electric field from the conductor to a first of the plurality of sensors differs from an attenuation of the electric field from the conductor to a second of the sensors. As mentioned above, a difference in attenuation may be obtained using a difference in distance between the conductor and the units and/or using different attenuating material between the conductor and the units.

In another manner, the internal field of a first of the plurality of sensors differs from the internal field of a second of the sensors. As described above, a difference in the relation between the electric field and the internal field allow for simultaneous detection of the signal in multiple units and thus a higher sensitivity of the determination.

It may be desired that some of or all of the units operate the separating means to go to the second mode at the same time, so that the same electric field strength is compared to different internal field strengths or at least so that different relations between the field strengths of the electric field and the internal field are compared at the same time.

Alternatively, the units may be operated to bring the separating element to the second means at different points in time so that the electric field is compared to the internal fields at different points in time. In this manner, information may be obtained over time at not at a single point in time.

In one embodiment, the signal is periodic and steps a), b) and c) are performed a plurality of points in time, where a first of the plurality of points in time and a second point in time of the plurality of points in time are at different positions in the period of the signal. In this manner, different portions or positions of the period of the signal may be determined at different points in time and often in different periods of the signal.

### Field of use

The main usage scenario for the present invention is for sampling the waveform carried on a signal line in a cryogenic environment. Many quantum computer applications rely on fast waveforms transmitted to control qubits in a cryogenic environment. Other cryogenic applications include interconnections to logical electronic circuits, analogue hardware, sensors and detectors, for example for astronomy.

The signal carrying path may be a transmission line on a chip or printed circuit board, alternatively a coaxial line or exposed wiring in single conductors or pairs. The coupling of the field potential in the signal line to the sampling double dot may be achieved by either remote electrical field action or via coupling the electrical potential via a local electrode from the signal path onto the double dot.

When coupled to a signal line, the double dot samples the electrical field potential with a binary outcome by comparing the external field components (from the signal path) with the predefined (e.g. gate controlled) internal field. It is thereby possible to set and control the detection threshold of the double dot. Sampling may be repeated with different threshold settings to achieve more than binary resolution to the external field components. Alternatively, several double dots may be placed with different coupling strength (e.g. at different distance from the signal line) to achieve a higher resolution.

### Figure description

In the following, preferred embodiments will be described with reference to the drawing, wherein:
- Figure 1 illustrates a conductor with sensors at different distances,
- Figure 2 illustrates how to force a particle into one of two positions,
- Figure 3 illustrates a sensor type based on a double dot,
- Figure 4 illustrates a sensor type with multiple sensors with different attenuation,
- Figure 5 illustrates determination of a periodic signal and
- Figure 6 illustrates a prior art double quantum dot set-up.

### Description of the system

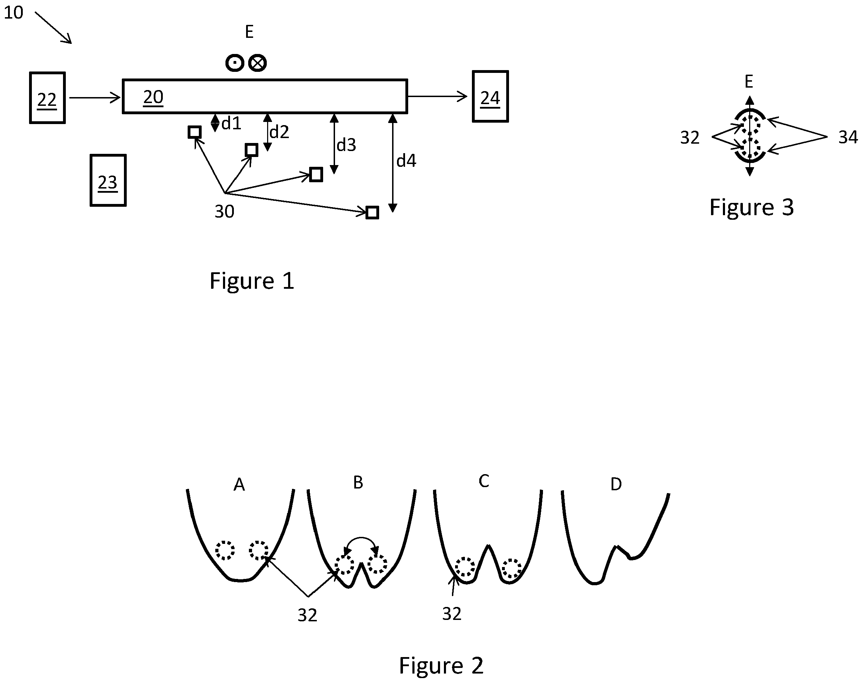

**Figure 1** illustrates a signal emitter 22 forwarding a signal through a conductor 20 to a cryogenic operated device or circuit, such as a DUT, qubit or the like 24. The conductor and the qubit are preferably positioned close to each other and are both cooled to below -200°C, such as below 1K.

The signal emitter 22 is capable of transmitting signals to the circuit, but due to the length of the conductor from room temperature and to the cooled space, noise, reflections, dissipation and other effects will interfere with the signal in the conductor so that the signal emitted by the emitter 22 will differ from that delivered from the conductor 20 to the circuit. The conductor 20 is a portion of the overall conductor, which is close to the circuit, so that the signal in the conductor 20 can be assumed to be the same or very similar to that reaching the circuit. The sensors (see below) may be positioned within 1cm, such as 0.5cm, such as 0.02cm from the circuit.

The system may be provided permanently in relation to the circuit, or it may be used for intermittent or even one-time calibrations.

One or more sensors 30 (described further below) may be positioned close to the conductor 20, such as within 5cm, such as 1cm such as 5mm, such as 500µm from the conductor.

In general, a conductor emits an electric field depending on its charge. The electric field is proportional to the signal carried by the conductor. The sensor is positioned close to the conductor and has (see further below) two storage positions between which a charged particle may travel under influence of the electric field. The sensor may additionally have an internal electric field directed oppositely to the electrical field of the conductor. The sensor then is sensitive to the combined internal and external electric fields and a measurement reveals which field is stronger. Ultimately, the resulting field will depend on the current carried by the conductor.

Preferably, the sensor comprises two storage positions. A charged particle may be in only one of these positions, so that the resolution of the measurement of the signal in the conductor is 1 bit.

The resolution may be increased by adjusting the internal electric field during repeated measurements to find the equality point of the internal and external electric fields of the sensor. The equality point is then proportional to the signal strength in the conductor.

Alternatively, providing an absorbing element between the conductor and the sensor may achieve the same effect as adjusting the internal electric field.

Alternatively, a number of sensors may be used in parallel to simultaneously read several sensors with different sensitivity to the electric field of the conductor. The difference in sensitivity may be achieved by different distances to the conductor, a different internal electric field, or through screening of the sensors with different strengths. Figure 1 shows a setup where 4 sensors allow for a 4 bit resolution measurement achieved through increased spacing to the conductor.

### Description of the sensor

When positioning a charged particle, such as an electron, or a hole, of the sensor 30 in the vicinity of the conductor, a force will be applied to the particle so that the particle will move due to the electric field from the conductor. The direction of movement will be determined by the charge of the particle, the electric field emitted from the conductor and any internal electric field in the sensor. In the following, we will use the terminology "particle" for any number of electrons, holes or any other charged particles.

The providing of an oppositely directed, field, such as an electric field, and preferably a field generated internally in the sensor, in the sensor allows for defining an electric field from the conductor which equals the internal field. If the conductor field is lower, such as if the current is lower, the internal field will prevail, and if the current is higher and the conductor field thus stronger, the conductor field will prevail. Prevailing meaning that that force will drive the particle.

The particle is provided in a system in which it is able to move between at least two positions, one closer to the conductor, and one more distant to the conductor. As mentioned, the position of the particle is determined by the electric field of the conductor and the electric field between the two positions in the sensor.

The two positions are described as two storage elements in each of which a particle may reside and between which the particle may move.

In figure 2, to the left, the particle 32 is seen in an energetic potential landscape defined in the sensor. The potential in the sensor may be adjusted to have one (A) or multiple (B,C,D) energetic minima, the potential may be symmetric (A,B,C) or asymmetric (D).

The particle is allowed to move in the potential as defined by its energy. Different positions are illustrated with broken circles.

When increasing the energy centrally in the well, a barrier divides the well into two troughs. When the added barrier is not high, as is seen in illustration (B), the particle may still have enough energy to move from one side to the other, but when the added energy is increased further, as is seen in illustration (C), the particle will be locked in one of the two positions i.e. the position determined by the direction and strength of the combined electric field, and thus the signal strength in the conductor 20.

In figure D, the energetic potential landscape is not symmetric. This may be caused by an internal field generated using electrodes biassing the charge from one storage position to the other. However, when an electric field is provided from the conductor, the landscape seen in D may convert into that seen in B.

Another way to describe the sensor is from a quantum mechanical perspective. The particle may be described as a waveform that lives in the potential landscape of the sensor. It extends across the potential well and its positional probability is given by the combined electric field and the energetic landscape it sees. When a barrier is introduced in the well, the particle may freely tunnel through the barrier, but the waveform will collapse and locate in one of the two positions when the energy of the barrier is increased sufficiently.

It may be of interest to equalize the electric field in the sensor to the signal from the conductor such that a change in the signal carried in the conductor will then determine the position of the particle in the sensor locations. This may be done by an asymmetric potential landscape, or by an external screening field across the sensor.

Finding the strength of the electric field in the sensor where the particle selects the other position is a proportional measurement of the signal strength carried in the conductor. With the particle in a locked position (i.e. with a high tunnel barrier), it may be detected and thus, it is possible to determine the relative strength of the signal in the conductor at the time when the barrier was introduced in the sensor. Different detection set-ups are described further below.

For a sufficiently fast sensor it is required that the particle can choose between the two positions quickly such as within 100µs, such as within 1µs, 100ns, Ins, 100ps, or within 1ps. Clearly, the central barrier is preferably controlled within a similarly fast timescale.

### Types of particle set-ups

In one embodiment, the sensor is defined as a so-called double-dot which has two dots or electrically conducting portions separated by a tunnel barrier, which are positioned so close to each other that charged particles may tunnel from one dot to the other. Each dot then defines one of the above positions or storage elements. The double-dot is defined sufficiently small such that distinct energy levels in the system only allow for a finite number of particles to reside in the double-dot.

The barrier strength may be adjusted to allow or prevent tunnelling between the two positions. The barrier may be controlled by a potential of a gate electrode of the sensor, but by other means may be used such as optical excitation.

Clearly, any number of charged particles, including electrons, holes, ions, cooper pairs and others may be provided in the double-dot. After sensing, the double-dot may be re-set with the barrier removed or reduced so as to be ready for another measurement. In another embodiment, the sensor is defined as a trapped ion system, where one or more ions are trapped in a two or more position system. The signal of the conductor may be coupled to the trapped ion directly, or by a coupling electrode. Depending on the strength of the signal and the emitted electric field the ion may move to a different position in the system. The position of the ion may then be detected by optical or by electrical measurements.

### Readout

Naturally, the readout type will depend on the sensor type.

For a charge stored in a dot, reflectometry may be used. In this case a reflectometer relies on a reflected RF signal probing the position of a charge. The impedance seen by the electromagnetic wave differs between the situation where the particle(s) is/are present in the dot and the situation where the particle is not there. This reflected RF signal may then be detected and converted into knowledge of whether the particle was there or not and thus knowledge of the relative strength of the electric field and ultimately the signal in the conductor.

For a charge stored in a dot, the reflectometry measurement may be achieved directly on one of the sensor dots by coupling through a gate electrode.

Alternatively, a coupled quantum point contact (QPC) may be used. The current through the dot depends on the presence or not of a charge in the coupled dot, and thus again give knowledge of the relative electric field.

### Determining also the signal strength

The above considerations cover mainly the sensing ability of one sensor with a 1 bit resolution to determine if the signal is smaller or larger than the reference signal or internal field. Clearly, the strength of the signal in the conductor will determine the size of the electric field which the particle experiences. In order to obtain information on this signal strength, multiple set-ups may be chosen between.

In one system, the internal field may be varied, and multiple detections made, so that the conductor field is compared to different internal field strengths.

In one embodiment illustrated in figure 3, one or more screening electrodes 34 may be used for providing an electric field directed parallel to or antiparallel to the electric field E, created by the conductor. In this manner, the field generated by the electrodes is subtracted from the field generated by the conductor. Then, from the position of the particle(s) in the dots 32 may be used for determining the size of the field E relative to the field generated by the electrodes.

In another embodiment, multiple detectors, d1, d2, d3 and d4 are provided as illustrated in figure 1. The distance from the conductor to the particle or the detector may be different for different detectors, as the field sensed by the particle of the individual detector will have a strength depending on this distance.

In yet another embodiment illustrated in figure 4, the detectors 30 are provided at the same distance to the conductor 20 but a damping material 26 is provided between the detectors and the conductor, where damping material has different thicknesses t1, t2, t3 and t4 between each detector and the conductor. Instead of or in addition to different thicknesses, materials with different damping properties may be used. Thus, the damping material will dampen the electrical signal differently at the different positions of the detectors. Again, the output of the detectors may then be used for determining the size of the current. Clearly, the parameters of the damping material and the distance may be selected for each detector independently of the others.

Clearly, the resolution with which the strength of the signal may be determined will then depend on the number of detectors. Thus, any number of detectors, such as 2, 4, 8, 16, 32, 64, 128, 256, 512, 1024 or more may be desired. Thus, the signal may be determined with any resolution.

If the signal is periodic, it may be detected with a higher resolution even with fewer detectors (see below).

Naturally, the embodiments may be combined so that one or more, such as all detectors of figure 1 or the detectors of figure 4 also has/have electrodes defining a local field parallel to or anti-parallel to the field of the conductor (for a predetermined signal strength).

### Mode of operation

The preferred mode of operation of the presented embodiments is the operation as a sampling oscilloscope, see figure 5 and https://www.aboutcircuit.com/sampling-oscilloscope-working-block-diagram/ especially when the signal in the conductor is periodic. A periodic signal is applied to the conductor 20 and the sensors measure the electric field from the conductor over many periods of the signal. The measured data can be used to reconstruct a single period of the signal by measuring the signal at appropriate points in time. For the operation as a sampling oscilloscope, it is required that the sensors measurement time is as short as the desired time resolution requires. For the above-described sensors this means that the barrier in the sensor is raised within the required time frame to lock the particle position, the readout of the sensor may be considerably slower.

A high resolution of the signal may be achieved in different ways. For a one-sensor system the same point of the signal period is probed several times while the internal field or the screening field of the sensor is adjusted until the signal strength at that point is found with the desired resolution, this process is repeated for all points in such a way to reconstruct the full signal period. For multiple sensors, the sensor sensitivity is tuned differently, by distance to the signal or by screening or in other suitable ways. During the operation, all sensors are operated at the same time, so as to determine the field at the same time, and the resolution of the signal depends on the number of sensors used.

The sensors are read out after the measurement. This may be done sequentially or in parallel before the next sensing operation is initiated. Alternatively, the sensing results may be stored in a memory and read-out at a later time.

### Error signal

Clearly, from the above methods the strength of the signal in the conductor may be determined. This may be used for generating information of a signal travelling in the conductor and thus that fed to the circuit.

An alternative manner of using the above sensors and especially the sensors of figure 3 comprising electrodes is to feed to the electrodes a signal corresponding to that desired on the conductor 10. As described, the signal actually fed into the conductor, often remotely, will not correspond to the signal carried by the proximal conductor close to the circuit.

Then, when feeding the desired signal to the electrodes, if the signal in the conductor 20 was as desired, the electrodes would counteract the electric field of the conductor so that the particle in the sensor would have a minimal to no field to move in. The output of the sensor thus would be undefined or altering between the two positions, as the sensor is at the balance point where the two signals correspond.

However, if the signal in the conductor is not balancing that fed to the electrodes, the resulting field sensed by the particle may be detected using the detector, as the particle's position would reflect this resulting field. The output of the detector may then be taken as an error signal used for correcting the signal fed to the conductor 10, until the balance point for the signal is found.

This may then be implemented as a standard feed-back technique where the signal fed into the conductor may be varied until the sensor senses the balance point.

### Periodic signal

It is noted that the above set-ups may comprise only a single sensor which is able to sense the field strength at a certain maximum frequency. The detection of the charge in dot-based set-ups often is much slower than the actual sensing of the field and locking the charge in the selected position. If multiple sensors are provided, the signal may be sensed more often, and/or the strength may be determined with a higher resolution.

Naturally, if the signal fed to the conductor and the generated E field is periodic, knowledge of the signal may be generated over time, such as when detecting the field at different points in time within a period of the signal. In this manner, a simple sensor may over time build a rather detailed knowledge of the signal in the conductor.

At the same point in time of the period, a single sensor, as seen in figure 3, with electrodes may have the voltage over the electrodes increased over time so as to more precisely determine the balance point and thus the signal strength at that point in time. This may be repeated for other points in time of the period.

Electronics 23 are provided for receiving the output of the detector(s) and/or controlling the detector(s). The electronics 23 may be cooled to the low temperature at the circuit, may be at room temperature or any temperature between these extreme temperatures. The electronics 23 may be a unitary circuit or multiple circuits. Multiple circuits may be distributed and in communication with each other if desired.

## Claims

1. A cryogenic operated sensor, the sensor comprising:
- a conductor configured to supply an electric signal,
- a first and a second storage element each configured to store at least one charged particle, the first and second storage elements being positioned so that a current in the conductor creates an electrical field forcing a charged particle in the first storage element in a direction toward one of the first storage position and the second storage element,
- a separating element configured to alter between a first mode and a second mode, where:
∘ in the first mode, the separating element allows a charged particle to move between the first and second storage positions and
∘ in the second mode, the separating element prevents charged particles from moving between the first and second storage positions and
- a detector for detecting in which of the first and second storage element comprises a charged particle.

2. A sensor according to claim 1, further comprising a field generator configured to generate, in the first and second storage elements, an internal field oppositely directed to the electrical field.

3. A sensor according to claim 2, further comprising a controller configured to:
- control the field generator and the separating element,
- receive an output from the detector and
- generate information relating to a current or signal carried by the conductor.

4. A sensor according to any of the preceding claims, wherein each of the first and second storage elements comprises a quantum dot.

5. A sensor according to any of the preceding claims, wherein the separating element comprises one or more electrodes configured to generate a barrier between the first and second positions, the barrier, in the first mode, being sufficiently low for the charged particle to pass the barrier, and, in the second mode, being sufficiently high for the charged particle to be prevented from passing the barrier.

6. A sensor according to any of the preceding claims, the sensor comprising a plurality of units each comprising a first and a second storage element, a separating element, a field generator and a detector, wherein the field generators of one unit and the field generator of another of the units are configured to generate different field strengths.

7. A sensor according to any of the preceding claims, the sensor comprising a plurality of units each comprising a first and a second storage element, a separating element and a detector, wherein the storage elements of one unit and the storage elements of another of the units are provided at different distances to the conductor.

8. A sensor according to any of the preceding claims, the sensor comprising a plurality of units each comprising a first and a second storage element, a separating element and a detector, wherein:
- a first damping material is provided between the conductor and the storage elements of one unit and
- a second damping material is provided between the conductor and the storage elements of another unit, the first and second damping materials having different damping of the electrical field.

9. An assembly comprising a sensor according to any of the preceding claims and a cryogenically operated circuit or device supplied by the electrical signal in the conductor.

10. A method of operating the sensor according to any of the preceding claims, the method comprising:
a) supplying the signal to the conductor,
b) the separating element altering from the first mode to the second mode,
c) detecting in which storage position the charged particle is.

11. The method according to claim 10, wherein steps a) and b) are performed simultaneously, the method further comprising the step of, during steps a) and b), feeding an internal field, opposite to the electrical field, to the first and second storage elements.

12. The method according to claim 11, further comprising the step of, based on the internal field and the result of step c), generating information relating to the signal.

13. The method of claim 12, wherein the step of feeding the internal field comprises feeding an internal field corresponding to a first signal, and wherein the step of generating the information comprises generating information relating to a difference between the signal and the first signal.

14. The method of any of claims 10-13, wherein step b) comprises raising a barrier between the first and second storage positions from, in the first mode, a level being sufficiently low for the charged particle to pass the barrier, to, in the second mode, a level being sufficiently high for the charged particle to be prevented from passing the barrier.

15. The method of claim 14, wherein the sensor comprises one or more electrodes, and wherein the raising of the barrier comprising providing a voltage to the one or more electrodes.
